# EUROPÄISCHE PATENTSCHRIFT

(11) **EP 1 198 831 B1**
(45) Veröffentlichungstag und Bekanntmachung des Hinweises auf die Patenterteilung: **22.11.2006**
(21) Anmeldenummer: 00952857.1
(22) Anmeldetag: 21.06.2000
(51) Int. Cl.: H01L 21/48, H01L 23/498

(54) **VERFAHREN ZUM SELEKTIVEN BESCHICHTEN KERAMISCHER OBERFLÄCHEN**
METHOD FOR SELECTIVELY COATING CERAMIC SURFACES
PROCEDE PERMETTANT DE RECOUVRIR SELECTIVEMENT DES SURFACES CERAMIQUES

(30) Priorität: 03.07.1999 DE 19930782
(43) Veröffentlichungstag der Anmeldung: 24.04.2002
(73) Patentinhaber: ROBERT BOSCH GMBH, 70442 Stuttgart (DE)
(72) Erfinder: ROETHLINGSHOEFER, Walter, D-72766 Reutlingen (DE); BOEHM, Manfred, D-71120 Grafenau (DE)
(86) Internationale Anmeldenummer: PCT/DE2000/002023
(87) Internationale Veröffentlichungsnummer: WO 2001/003174

(56) Entgegenhaltungen:
- EP-A- 0 011 738
- EP-A- 0 270 241
- US-A- 5 906 859

## Beschreibung

Die Erfindung betrifft ein Verfahren zum Behandeln der Oberfläche eines keramische Oberflächenbereiche und metallische Oberflächenbereiche aufweisenden Keramik-Hybrid-Substrates.

### Stand der Technik

Der Einsatz keramischer (glaskeramischer) Hybrid-Substrate ist beispielsweise zum Aufbau elektrischer Schaltungsanordnungen bekannt. Derartige elektrische Schaltungsanordnungen werden in vielfältigen Bereichen der Technik, beispielsweise im Kraftfahrzeug-Elektronikbereich für eine Motorsteuerung, Antiblockiersteuerung oder dergleichen eingesetzt. Die keramischen Hybrid-Substrate beinhalten prozessierte elektronische Bauelemente und metallische Leiterbahnen, über die eine Kontaktierung der Hybrid-Substrate erfolgen kann. Bekannt ist, derartige Keramik-Hybrid-Substrate durch Laminieren einzelner Funktionsschichten, die elektrische Verbindungsleitungen, integrierte Schaltungsbestandteile, mikromechanische Strukturen oder dergleichen aufweisen können, zu erhalten. Eine derartige, aus mehreren Funktionsschichten bestehende Verbundanordnung wird nachfolgend gesintert, so daß das fertige Keramik-Hybrid-Substrat entsteht. Das fertige Keramik-Hybrid-Substrat besitzt also eine Oberflächenstruktur, die teilweise von keramischen Oberflächenbereichen und teilweise von in diesen eingebetteten metallischen Oberflächenbereichen (Leiterbahnen, Pads) besteht. Durch eine Miniaturisierung derartiger Keramik-Hybrid-Substrate kann ein Abstand zwischen benachbarten metallischen Bereichen im Bereich < 100 µm liegen. Um derartige, in sogenannter Fineline-Technik integrierte metallische Oberflächenbereiche anschließend kontaktieren zu können, beispielsweise durch Bonden, Aufbringen elektrisch leitfähiger Klebstoffe oder dergleichen, ist bekannt, die metallischen Oberflächenbereiche nachzubearbeiten, indem beispielsweise ein Kontaktmetall (Silber, Gold oder dergleichen) in einem chemischen Abscheideprozeß auf die metallischen Oberflächenbereiche aufgebracht wird. Hierbei werden die Keramik-Hybrid-Substrate in chemischen Bädern behandelt, die teilweise aggressive und ätzende, die Oberfläche der keramischen Oberflächenbereiche angreifende Substanzen enthalten. Ferner ist nachteilig, daß während der Abscheidung des Kontaktmetalls in chemischen Bädern auch auf den keramischen Oberflächenbereichen es zu Ablagerungen von Metallen kommen kann, die - insbesondere in Anbetracht der geringen Abstände der metallischen Oberflächenbereiche - zu Kurzschlüssen führen können. Ferner ist nachteilig, daß bei einem nachfolgenden Kontaktieren der metallischen Oberflächenbereiche, beispielsweise mit einem elektrisch leitfähigen Klebstoff, dieser zum Fließen (Ausbluten) neigt, so daß ebenfalls Kurzschlüsse zwischen benachbarten metallischen Bereichen entstehen können.

### Vorteile der Erfindung

Das erfindungsgemäße Verfahren mit den im Anspruch 1 genannten Merkmalen und das erfindungsgemäße Keramik-Hybrid-Substrat mit den im Anspruch 16 genannten Merkmalen bietet demgegenüber den Vorteil, daß eine nachfolgende Bearbeitung der metallischen Oberflächenbereiche beziehungsweise eine nachfolgende Kontaktierung der metallischen Oberflächenbereiche bei reduzierter Neigung zu Kurzschlüssen zwischen benachbarten metallischen Oberflächenbereichen erfolgen kann. Dadurch, daß die keramischen Oberflächenbereiche des Keramik-Hybrid-Substrates verestert werden, wird vorteilhaft erreicht, daß die keramischen Oberflächenbereiche selektiv bei den nachfolgenden Nachbehandlungen in chemischen Bädern geschützt sind. Infolge der Veresterung entsteht an den keramischen Oberflächenbereichen eine monomolekulare Oberflächenschicht, die chemisch und thermisch resistent ist, so daß insbesondere auf die metallischen Oberflächenbereiche chemisch abgeschiedene Metallisierungen sich nicht an den keramischen Oberflächenbereichen ablagern können. Ferner führt dieses selektive Verestern der keramischen Oberflächenbereiche zu einer Veränderung der Oberflächenspannung, so daß auf die metallischen Oberflächenbereiche aufgebrachte elektrisch leitfähige Klebstoffe nicht zum Fließen auf die keramischen Oberflächenbereiche neigen.

Bevorzugt ist vorgesehen, daß die Oberfläche des Keramik-Hybrid-Substrates mit einer auf die keramische Oberfläche abgestimmten organische Bestandteile aufweisenden Lösung behandelt wird. Diese Behandlung erfolgt vorzugsweise durch ein Tauchbad, Schwallbenetzung, Aufsprühen, Aufrakeln oder dergleichen. Durch Benetzen der Oberfläche mit der die organischen Bestandteile aufweisenden Lösung lagert sich diese in Mikroporen der keramischen Oberflächenbereiche ab. Durch eine bevorzugt vorgesehene nachfolgende Wärmebehandlung findet eine Vernetzung der organischen Bestandteile der Lösung mit Gitterstrukturen an den keramischen Oberflächenbereichen statt. Hierdurch kommt es zum Entstehen der chemisch und thermisch stabilen (resistenten) Oberflächenbeschichtung der keramischen Oberflächenbereiche. Durch bevorzugt dabei vorgesehenes nachfolgendes Entfernen nicht vernetzter Reste der die organischen Bestandteile aufweisenden Lösung wird diese auf den metallischen Oberflächenbereichen, wo keine Haftungswirkung (Vernetzung) erfolgt, entfernt. Die metallischen Oberflächenbereiche stehen somit in der prozessierten Form und mit den ursprünglichen Eigenschaften für die weitere Verarbeitung zur Verfügung.

Eine bevorzugte Anwendung des erfindungsgemäßen Verfahrens ergibt sich bei auf Siliziumbasis hergestellten Keramik-Hybrid-Substraten, bei denen die keramischen Oberflächenbereiche mit einer Silizium als organische Komponente enthaltenden Lösung (Siloxan) behandelt wird. Die Konzentrationen organischer Siliziumverbindungen liegen bevorzugt zwischen 0,1 und 1 % - bezogen auf das Gesamtvolumen - der Lösung vor. Durch eine derartige Behandlung läßt sich nach der Vernetzung der Lösung mit den keramischen Oberflächenbereichen eine Siliziumoxid- beziehungsweise Siliziumdioxidoberflächenschicht erzielen, die eine gute Resistenz gegen chemische und thermische Einflüsse aufweist.

Weitere bevorzugte Ausgestaltungen der Erfindung ergeben sich aus den übrigen, in den Unteransprüchen genannten Merkmalen.

### Zeichnungen

Die Erfindung wird nachfolgend in Ausführungsbeispielen anhand der zugehörigen Zeichnungen näher erläutert. Es zeigen:
- Figuren 1 bis 3: verschiedene Phasen der Behandlung der keramischen Oberflächenbereiche und
- Figuren 4 und 5: schematisch die Veresterung der kerasischen Oberflächenbereiche.

### Beschreibung der Ausführungsbeispiele

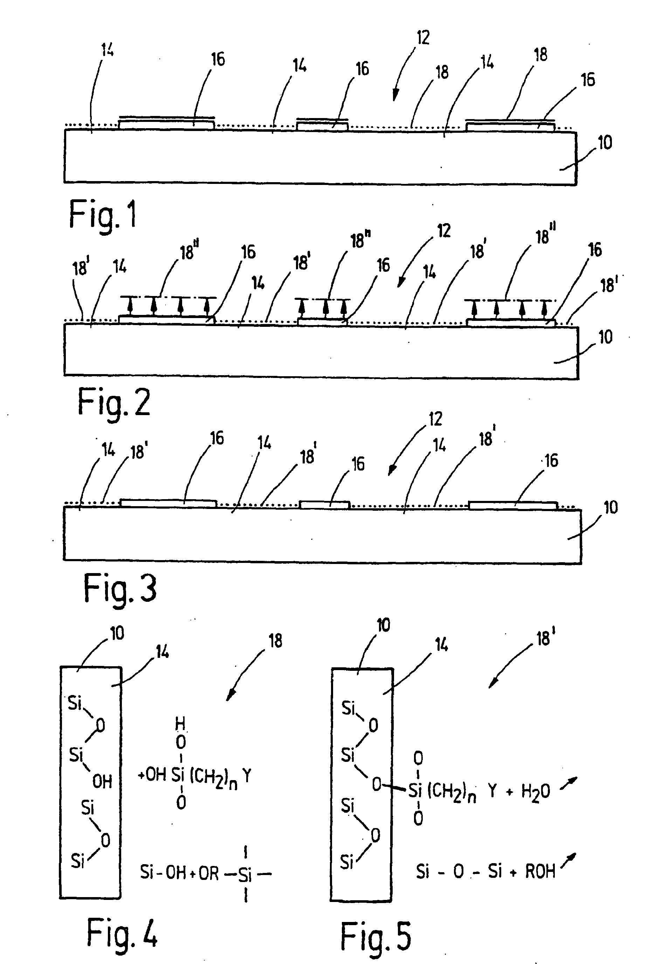

In den Figuren 1 bis 3 ist jeweils schematisch ein Keramik-Hybrid-Substrat 10 (LTCC-Mikrohybrid-Substrat) dargestellt. An seiner Oberfläche 12 besitzt das Keramik-Hybrid-Substrat 10 keramische Oberflächenbereiche 14 und metallische Oberflächenbereiche 16. Die metallischen Oberflächenbereiche 16 können beispielsweise Bondpads, Klebepads oder dergleichen sein. Die Prozessierung derartiger Keramik-Hybrid-Substrate 10 ist allgemein bekannt, so daß im Rahmen der vorliegenden Beschreibung hierauf nicht näher eingegangen werden soll.

Nachfolgend wird das erfindungsgemäße Verfahren zum Erzielen einer Oberflächenvergütung der keramischen Oberflächenbereiche 14 erläutert.

Zunächst wird, wie in Figur 1 angedeutet ist, die Oberfläche 12 mit einer organische Komponenten aufweisenden Lösung 18 beaufschlagt. Dieses Beaufschlagen mit der Lösung 18 kann beispielsweise durch ein Tauchbad, Aufsprühen, Schwallbenetzung oder dergleichen erfolgen. Hierdurch lagert sich die Lösung 18 auf den keramischen Oberflächenbereichen 14 und den metallischen Oberflächenbereichen 16 ab. Überflüssige Lösungsmengen werden mechanisch, beispielsweise durch Abstreifen, Abblasen, Abschleudern oder dergleichen, entfernt. Hierdurch kommt es zur Ausbildung einer dünnen Schicht der Lösung 18 auf der gesamten Oberfläche 12, also auf den keramischen Oberflächenbereichen 14 und den metallischen Oberflächenbereichen 16. Die Lösung 18 haftet an der Oberfläche 12 durch Oberflächenspannungen an und dringt in Oberflächenporen ein.

Die Lösung 18 besteht beispielsweise aus einer 0.1 prozentigen Siloxanlösung.

Figur 4 zeigt ausschnittsweise einen keramischen Oberflächenbereich 14 des Keramik-Hybrid-Substrates 10. Das Keramik-Hybrid-Substrat 10 besteht beispielsweise aus einer silizium-Glaskeramik. Derartige Silizium-Glaskeramiken besitzen reaktive Gruppen (OH-Gruppen). Ferner ist in Figur 4 die Benetzung mit der Lösung 18, die in den konkreten Ausführungsbeispielen Silane als organische Komponenten enthält, dargestellt.

Nachfolgend erfolgt eine Wärmebehandlung des Keramik-Hybrid-Substrates 10, beispielsweise bei einer Temperatur von zirka 100 °C und für eine Zeitdauer von zirka 30 Minuten. Hierdurch kommt es zu einer Silanisierung (Veresterung) der keramischen Oberflächenbereiche 14. In Figur 5 ist die entstehende Vernetzung verdeutlicht. Silizium lagert sich an den reaktiven Gruppen unter Ausbildung einer Si-O-Si-Struktur an. Derartige Siliziumstrukturen zeichnen sich, wie bekannt, durch chemisch und thermisch stabile Eigenschaften aus. Freie Hydroxylgruppen (OH-Gruppen) als reaktive Gruppen reagieren mit silizumhaltigem Edukt, so daß es zur Ausbildung der Si-O-Si-Bindung (Siloxane) kommt.

Anschließend werden, wie Figur 2 verdeutlicht, die mit den keramischen Oberflächenbereichen 14 nicht vernetzten Restmengen 18" der Lösung 18 entfernt.

Dieses Entfernen erfolgt vorzugsweise durch Abwaschen mit einem Lösungsmittel, beispielsweise Isopropanol. Hierdurch entsteht die in Figur 3 angedeutete Oberflächenbeschichtung der keramischen Oberflächenbereiche 14 mit den Siliziumkomponenten 18'. Die metallischen Oberflächenbereiche 16 reagieren nicht mit den organischen Komponenten, so daß diese nach Ablösen der Restmengen 18" chemisch und mechanisch unverändert vorliegen.

Durch einen nachfolgenden Einbrennvorgang kann eine thermische Zersetzung der organischen Komponente R₃ erfolgen, so daß in den keramischen Oberflächenbereichen 14 eine Siliziumdioxidschicht, wie es in der unteren Strukturdarstellung in Figur 5 angedeutet ist, entsteht.

Durch das erfindungsgemäße Verfahren wird erreicht, daß das Keramik-Hybrid-Substrat 10 keramische Oberflächenbereiche 14 aufweist, die eine hohe chemische Stabilität gegenüber im weiteren Herstellungsprozeß auftretender Ätzangriffe besitzen. Insbesondere bei nachfolgender Abscheidung von Metallen auf die metallischen Oberflächenbereiche 16, beispielsweise von Silber, Nickel, Palladium, Gold oder dergleichen, können Fehlabscheidungen auf die zwischen den metallischen Oberflächenbereichen 16 liegenden keramischen Oberflächenbereiche 14 vermieden werden. Somit ist die Gefahr von Kurzschlüssen reduziert. Ferner ist die Oberflächenspannung der keramischen Oberflächenbereiche 14 derart verändert, daß auf die metallischen Oberflächenbereiche 16 aufgebrachte elektrisch leitfähige Klebstoffe nicht zum Fließen neigen, so daß ebenfalls Brückenbildungen oder dergleichen zwischen benachbarten metallischen Oberflächenbereichen 16 erheblich reduziert sind.

Die erfindungsgemäß vorgesehene Modifizierung der keramischen Oberflächenbereiche 14 kann in den Gesamtherstellungsprozeß der Keramik-Hybrid-Substrate 10 aufweisenden Schaltungsanordnung zu unterschiedlichen Prozeßfortschritten integriert sein. Nach einer ersten Ausführungsvariante erfolgt die Silanisierung der keramischen Oberflächenbereiche 14 nach Herstellung des in den Figuren 1 bis 3 gezeigten Keramik-Hybrid-Substrates 10, das heißt vor nachfolgenden Dickschichtprozessen, Einbrennprozessen, Platingprozessen, Bestücken des Substrates 10 mit Leitkleber, Bonden oder dergleichen. Hier wird insbesondere eine Schutzbeschichtung der keramischen oberflächenbereiche 14 gegen chemische Angriffe in den chemischen Bädern beim Plating (Abscheiden von Metallen auf die metallischen Oberflächenbereiche 16) erzielt.

Nach einer weiteren Variante kann die Silanisierung der keramischen Oberflächenbereiche 14 nach den Dickschichtprozessen und Einbrennprozessen erfolgen. Diese erfolgt dann vor dem Plating, Leitkleberprozessen beziehungsweise Bonden. Hier ergeben sich die gleichen Vorteile wie bei der ersten Variante.

Schließlich kann auch vorgesehen sein, daß die Silanisierung der keramischen Oberflächenbereiche 14 nach dem Plating (Metallisieren) der metallischen Oberflächenbereiche 14 erfolgt. So ist zwar eine Schutzbeschichtung während des Einwirkens der chemischen Bäder auf die keramischen Oberflächenbereiche 14 nicht gegeben. Jedoch ist bei einem nachfolgenden Bestücken der Substrate 10, beispielsweise mit elektrischen leitfähigen Klebstoffen oder Bonden durch Beeinflussung der Oberflächenspannung das Fließen der Haftmittel reduziert.

Entsprechend der gewünschten Prozessierung kann somit die Siloxanisierung der keramischen Oberflächenbereiche 14 an unterschiedlichen Zeitpunkten der Prozessierung eingebunden werden.

## Patentansprüche

1. Verfahren zum Behandeln der Oberfläche eines keramische Oberflächenbereiche und metallische Oberflächenbereiche aufweisenden Keramik-Hybrid-Substrates, **dadurch gekennzeichnet, dass** die keramischen Oberiiächenbereiche (14) verestert werden.

2. Verfahren nach Anspruch 1, **dadurch gekennzeichnet, dass** die keramischen Oberflächenbereiche (14) mit einer auf die keramische Struktur abgestimmten, organische Bestandteile aufweisenden Lösung (18) behandelt werden.

3. Verfahren nach einem der vorhergehenden Ansprüche, **dadurch gekennzeichnet, dass** die keramische Struktur auf Siliziumbasis hergestellt ist und die Lösung Silizium enthält.

4. Verfahren nach einem der vorhergehenden Ansprüche, **dadurch gekennzeichnet, dass** als Lösung (18) eine Siloxan-Lösung verwendet wird.

5. Verfahren nach Anspruch 4, **dadurch gekennzeichnet, dass** die Lösung zwischen 0,1 und 1 % Siloxan und 99,9 bis 99 % Isopropanol - bezogen auf 100 % Gesamtvolumen - enthält.

6. Verfahren nach einem der vorhergehenden Ansprüche, **dadurch gekennzeichnet, dass** die Lösung (18) durch Tauchbeschichtung aufgebracht wird.

7. Verfahren nach einem der Ansprüche 1 bis 5, **dadurch gekennzeichnet, dass** die Lösung (18) durch Aufsprühen aufgebracht wird.

8. Verfahren nach einem der vorhergehenden Ansprüche, **dadurch gekennzeichnet, dass** überflüssige Lösung (18) mechanisch entfernt wird.

9. Verfahren nach Anspruch 8, **dadurch gekennzeichnet, dass** die überflüssige Lösung (18) abgestreift wird.

10. Verfahren nach Anspruch 8, **dadurch gekennzeichnet, dass** die überflüssige Lösung (18) abgeblasen wird.

11. Verfahren nach einem der vorhergehenden Ansprüche, **dadurch gekennzeichnet, dass** die mit der Lösung kontaktierte Oberfläche wärmebehandelt wird.

12. Verfahren nach Anspruch 11, **dadurch gekennzeichnet, dass** die Wärmebehandlung bei einer Temperatur von zirka 100°C erfolgt.

13. Verfahren nach Anspruch 11 oder 12, **dadurch gekennzeichnet, dass** die Wärmebehandlung für eine Zeitspanne zwischen 0,4 und 0,6 Stunden erfolgt.

14. Verfahren nach einem der vorhergehenden Ansprüche 11 bis 13, **dadurch gekennzeichnet, dass** nach der Wärmebehandlung nicht vernetzte Lösungsbestandteile (18") entfernt werden.

15. Verfahren nach Anspruch 14, **dadurch gekennzeichnet, dass** nicht vernetzte Lösungsbestandteile (18") abgewaschen werden.

16. Keramisches Hybrid-Substrat mit einer keramische Oberflächenbereiche und metallische Oberflächenbereiche aufweisenden Oberfläche, **dadurch gekennzeichnet, dass** die keramischen Oberflächenbereiche (14) verestert sind.

## Claims

1. Method for treating the surface of a ceramic hybrid substrate having ceramic surface regions and metallic surface regions, **characterized in that**
the ceramic surface regions (14) are esterified.

2. Method according to Claim 1, **characterized in that** the ceramic surface regions (14) are treated with a solution (18) which is specifically formulated for the ceramic structure and has organic constituents.

3. Method according to one of the preceding claims, **characterized in that** the ceramic structure is produced on a silicon basis and the solution contains silicon.

4. Method according to one of the preceding claims, **characterized in that** a siloxane solution is used as the solution (18).

5. Method according to Claim 4, **characterized in that** the solution contains between 0.1 and 1% siloxane and 99.9 to 99% isopropanol - with respect to 100% total volume.

6. Method according to one of the preceding claims, **characterized in that** the solution (18) is applied by dip coating.

7. Method according to one of Claims 1 to 5,
**characterized in that** the solution (18) is applied by spraying.

8. Method according to one of the preceding claims, **characterized in that** excess solution (18) is mechanically removed.

9. Method according to Claim 8, **characterized in that** the excess solution (18) is wiped off.

10. Method according to Claim 8, **characterized in that** the excess solution (18) is blown off.

11. Method according to one of the preceding claims, **characterized in that** the surface contacted by the solution is heat-treated.

12. Method according to Claim 11, **characterized in that** the heat treatment takes place at a temperature of around 100°C.

13. Method according to Claim 11 or 12, **characterized in that** the heat treatment takes place for a time period of between 0.4 and 0.6 of an hour.

14. Method according to one of the preceding Claims 11 to 13, **characterized in that**, after the heat treatment, uncrosslinked solution constituents (18'') are removed.

15. Method according to Claim 14, **characterized in that** uncrosslinked solution constituents (18'') are washed off.

16. Ceramic hybrid substrate with a surface having ceramic surface regions and metallic surface regions, **characterized in that** the ceramic surface regions (14) are esterified.

## Revendications

1. Procédé permettant le traitement de la surface d'un substrat hybride en céramique présentant des zones superficielles en céramique et d'autres en métal,
**caractérisé en ce que**
les zones superficielles en céramique (14) sont estérifiées.

2. Procédé selon la revendication 1,
**caractérisé en ce que**
les zones superficielles en céramique (14) sont traitées par une solution (18) présentant des composants organiques et adaptée à la structure céramique.

3. Procédé selon l'une quelconque des revendications précédentes,
**caractérisé en ce que**
la structure céramique est fabriquée sur une base de silicium et la solution contient du silicium.

4. Procédé selon l'une quelconque des revendications précédentes,
**caractérisé en ce qu'**
on utilise pour la solution (18) une solution de siloxane.

5. Procédé selon la revendication 4,
**caractérisé en ce que**
la solution contient entre 0,1 et 1 % de siloxane et entre 99,9 et 99 % d'isopropanol (par rapport à un volume total de 100 %).

6. Procédé selon l'une quelconque des revendications précédentes,
**caractérisé en ce que**
la solution (18) est appliquée par trempage.

7. Procédé selon l'une quelconque des revendications 1 à 5,
**caractérisé en ce que**
la solution (18) est appliquée par vaporisation.

8. Procédé selon l'une quelconque des revendications précédentes,
**caractérisé en ce que**
l'excédent de solution (18) est retiré mécaniquement.

9. Procédé selon la revendication 8,
**caractérisé en ce que**
l'excédent de solution (18) est enlevé par stripage.

10. Procédé selon la revendication 8,
**caractérisé en ce que**
l'excédent de solution (18) est enlevé par soufflage.

11. Procédé selon l'une quelconque des revendications précédentes,
**caractérisé en ce que**
la surface en contact avec la solution est traitée à chaud.

12. Procédé selon la revendication 11,
**caractérisé en ce que**
le traitement thermique a lieu à une température d'environ 100 °C.

13. Procédé selon la revendication 11 ou 12,
**caractérisé en ce que**
le traitement thermique a lieu pour une durée comprise entre 0,4 et 0,6 heure.

14. Procédé selon l'une quelconque des revendications 11 à 13,
**caractérisé en ce qu'**
après le traitement thermique on retire des composants de solution non réticulés (18").

15. Procédé selon la revendication 14,
**caractérisé en ce que**
des composants de solution (18") non réticulés sont nettoyés par lavage.

16. Substrat hybride en céramique avec une surface présentant des zones superficielles en céramique et d'autres en métal,
**caractérisé en ce que**
les zones superficielles en céramique (14) sont estérifiées.
